# EUROPÄISCHE PATENTSCHRIFT

(11) **EP 0 952 021 B1**
(45) Veröffentlichungstag und Bekanntmachung des Hinweises auf die Patenterteilung: **24.08.2005**
(21) Anmeldenummer: 99106083.1
(22) Anmeldetag: 26.03.1999
(51) Int. Cl.: B60J 7/043

(54) **Solardeckel für Fahrzeuge**
Solar panel for vehicle
Panneau solaire pour véhicule

(30) Priorität: 26.03.1998 DE 19813324
(43) Veröffentlichungstag der Anmeldung: 27.10.1999
(73) Patentinhaber: WEBASTO KAROSSERIESYSTEME GmbH, D-82131 Stockdorf (DE)
(72) Erfinder: Wecker, Reinhard, 82223 Eichenau (DE)
(74) Vertreter: Wiese, Gerhard

(56) Entgegenhaltungen:
- EP-A- 0 463 351
- DE-A- 3 830 484
- DE-A- 4 038 039
- DE-U- 8 808 782

## Beschreibung

Die Erfindung bezieht sich auf eine Anordnung mit einem Fahrzeugdach, mit einem Solardeckel zum wahlweisen Verschließen oder teilweisen Freilegen einer im Fahrzeugdach vorgesehenen Dachöffnung, der zwischen einer außenliegenden Deckelplatte und einer innenliegenden Abdeckung angeordnete Solarzellen aufweist, mit mindestens einem aus den Solarzellen gespeisten Verbraucher, der von dem Solardeckel getrennt ist, und mit einer Kontakteinrichtung zum Herstellen einer elektrischen Verbindung zwischen den Solarzellen und dem Verbraucher, wobei die Kontakteinrichtung deckelseitige sowie dachseitige Kontakte aufweist, die zumindest in einer Solardeckelstellung die elektrische Verbindung schließen, auch wenn eine Kante des Solardeckels über oder unter eine feste Dachhaut verschwenkt ist, und wobei die deckelseitigen oder die dachseitigen Kontakte mit Bezug zu ihren jeweiligen Gegenkontakten in Richtung auf diese federnd ausgebildet sind.

Aus der EP 0 463 351 B 1 ist eine derartige Anordnung bekannt, bei der eine aufwendig gestaltete Kontakteinrichtung den elektrischen Kontakt zwischen Verbraucher und Solarzellen in der vorderen Deckelendstellung schließt und bei geöffnetem oder teilweise geöffnetem Solardeckel den elektrischen Kontakt unterbricht. Im Unterschied hierzu ist bei dem in der DE 38 30 484 A1 offenbarten Solardeckel die Kontakteinrichtung so gestaltet, daß der elektrische Kontakt zwischen Verbraucher und Solarzellen unabhängig von der Stellung des Solardeckels immer gewährleistet ist. Gemeinsam ist diesen bekannten Solardeckeln, daß die Anbringung der deckelseitigen Kontakte am Solardeckel mit erheblichem Aufwand verbunden und daher kostenintensiv ist.

Die DE 40 22 928 C1 beschreibt ein Lüfterdach für Fahrzeuge, bei dem der Deckel in einem Ausführungsbeispiel als Solardeckel ausgebildet ist, der je nach Stellung eine deckelseitige Kontaktplatte mit einem an einem Rahmen des Deckels angebrachten Federkontakt in elektrische Verbindung bringt, um ein Lüftergebläse anzutreiben. Die deckelseitigen Kontakte sind bei diesem bekannten Solardeckel auf einer innenliegenden Abdeckung der Deckelplatte nachträglich angebracht und mit den Solarzellen elektrisch leitend verbunden. Um die elektrische Verbindung zwischen den deckelseitigen Kontakten und den Solarzellen vor mechanischer Beschädigung zu schützen, ist es notwendig, die Verbindungskabel zwischen ihrer Austrittsstelle aus der innenlegenden Abdeckung und den deckelseitigen Kontakten in geeigneter Weise zusätzlich abzudecken.

Der im Anspruch 1 angegebenen Erfindung liegt die Aufgabe zugrunde, eine Anordnung mit einem Solardeckel der eingangs genannten Art zu schaffen, bei dem die deckelseitigen Kontakte möglichst einfach und raumsparend ausgestaltet sind und dennoch hohe Ansprüche an mechanische und elektrische Zuverlässigkeit erfüllen.

Diese Aufgabe wird durch eine Anordnung mit den Merkmalen des Anspruchs 1 gelöst. Vorteilhafte Weiterbildungen der Erfindung sind Gegenstand der Unteransprüche.

Bei der erfindungsgemäßen Anordnung sind aufgrund der Integration der deckelseitigen Kontakte in den Solardeckel sämtliche elektrische Verbindungen zwischen den Solarzellen und den deckelseitigen Kontakten besonders gut gegen mechanische und korrosive Beanspruchung geschützt, und durch die deckelseitigen Kontakte wird kein unnötiger Bauraum beansprucht. Die Anbringung der Kontakte erfolgt auf einfache Weise mittels eines zwischen außenliegender Deckelplatte und innenliegender Abdeckung angeordneten Einbettungsmaterials, das aus Kunststoff ausgebildet ist und daher automatisch für eine elektrische Isolierung der Kontakte zu benachbarten Teilen sorgt. Bevorzugt ist vorgesehen, daß die federnd ausgebildeten Kontakte einen federnd vorgespannten Stößel oder Federkontakt und die Gegenkontakte einen unnachgiebigen Kontaktbereich aufweisen. Dadurch wird ein sicherer Kontakt auch bei Verschwenken der Hinterkante des Solardeckels oder beim Öffnen des Solardeckels gewährleistet, wenn dieser beim Verschieben von einer Deckelranddichtung abgehoben wird.

In weiterer Ausgestaltung des Solardeckels bilden die unnachgiebigen Kontaktbereiche Stromschienen, die mit den federnd vorgespannten Stößeln oder Federkontakten der federnd ausgebildeten Kontakte während des gesamten Öffnungsweges des Solardeckels in elektrischem Kontakt bleiben.

Der Solardeckel kann insbesondere so gestaltet sein, daß bei geöffnetem oder teilweise geöffnetem Solardeckel die deckelseitigen und die dachseitigen Kontakte die elektrische Verbindung zwischen Verbraucher und Solarzellen öffnen. Bei diesem Ausführungsbeispiel sind vorteilhafterweise die deckelseitigen Kontakte in der Nähe der Vorderkante der Deckelplatte angeordnet und weisen einen unnachgiebigen Kontaktbereich auf, der im wesentlichen nur in der vorderen Solardeckelendstellung mit den federnd ausgebildeten dachseitigen Kontakten in Kontakt steht. Die deckelseitigen Kontakte können dabei in einer gemeinsamen Kontaktplatte zusammengefaßt sein, die bevorzugt einen Stabilisierungskörper umfaßt, auf den die deckelseitigen Kontakte aufgebracht sind.

Um den mechanischen Verschleiß beim Öffnen und Schließen der Kontakte gering zu halten, kann wenigstens einer der Kontakte in einer Verschieberichtung des Solardeckels wirksame Auflauframpen aufweisen.

Vorzugsweise wird für die innenliegende Abdeckung eine Kunststoffolie verwendet, die im Bereich der deckelseitigen Kontakte Aussparungen aufweist. Dadurch ist nach Abschluß des Laminierprozesses an der innenliegenden Abdeckung im Bereich der deckelseitigen Kontakte keine Nacharbeit mehr notwendig.

Die deckelseitigen Kontakte werden bevorzugt beim Laminiervorgang mittels desselben Einbettungsmaterials an der Deckelplatte adhäsiv verbunden, welches auch zur Einbettung der Solarzellen dient. Alternativ ist es jedoch auch möglich, auf den deckelseitigen Kontakten einen Klebstoff aufzutragen, der den Erfordernissen der Materialpaarung von Deckelplatte und Kontakten besonders Rechnung trägt und der beim Laminiervorgang aushärtet.

Wird der Solardeckel mit einem angeschäumten oder angespritzten Kunststoffrahmen im Randbereich der Deckelplatte ausgeführt, so weist zweckmäßig der Kunststoffrahmen im Bereich der deckelseitigen Kontakte Aussparungen auf, die bereits im Anschäum- oder Anspritzverfahren angebracht werden.

Nachfolgend sind vorteilhafte Ausführungen der Erfindung anhand der Zeichnungen näher erläutert. Es zeigt:
- Fig. 1: eine Draufsicht auf einen Solardeckel,
- Fig. 2: einen Teilschnitt durch den Solardeckel entlang der Linie II-II der Fig. 1,
- Fig. 3: eine vergrößerte Darstellung des in Fig. 1 mit einem Kreis III angedeuteten Eckbereiches des Solardeckels,
- Fig. 4: eine Draufsicht auf eine abgewandelte Ausführungsform der deckelseitigen Kontakte,
- Fig. 5: eine Schnittdarstellung durch die Kontaktplatte entlang der Linie V-V der Fig. 4,
- Fig.6: einen Teilschnitt ähnlich Fig. 2 für einen Solardeckel gemäß einer abgewandelten Ausführungsform.

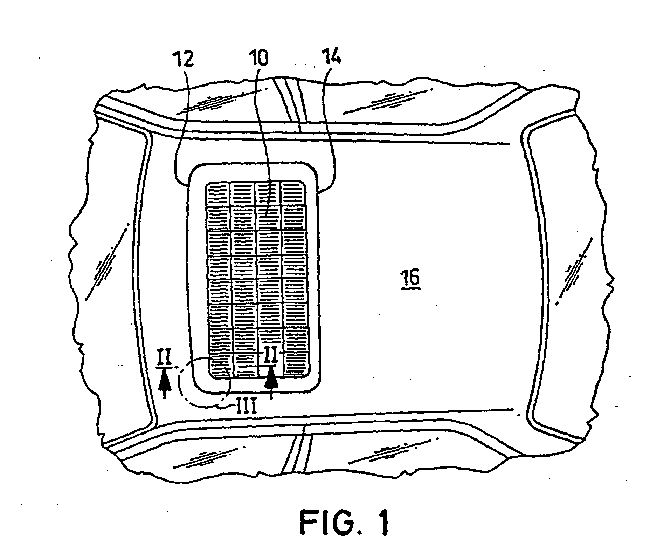

Bei der in den Fign. 1 bis 3 dargestellten Ausführungsform des Solardeckels 10 handelt es sich um einen rahmenlosen Solardeckel 10, der als Teil eines an sich bekannten Spoilerdaches mit seiner Hinterkante 14 über eine feste Dachhaut 16 ausgestellt und nach hinten über diese verschoben werden kann. An seiner Vorderkante 12 weist der Solardeckel 10 zwei deckelseitige Kontakte 30 auf, die über Zellenverbinder 28 elektrisch mit Solarzellen 22 verbunden sind. Die ihrerseits ebenfalls über Zellenverbindern 28 kontaktierten Solarzellen 22 sind mittels eines weichen Einbettungsmaterials 26 zwischen einer außenliegenden Deckelplatte 20 und einer innenliegenden Abdeckung 24 eingebettet. Als Einbettungsmaterial 26 kann beispielsweise ein Schmelzkleber, ein Gießharz oder eine transparente Klebefolie verwendet werden. Die außenliegende Deckelplatte 20 ist vorzugsweise eine Glasplatte, kann aber ebenso eine Kunststoffplatte z.B. aus Plexiglas sein. Für die innenliegende Abdeckung 24 wird bevorzugt eine Kunststoffolie eingesetzt, wobei alternativ Metall, insbesondere Aluminium, oder Glas zum Einsatz kommen kann.

Die deckelseitigen Kontakte 30 sind aus geeignetem Kontaktmaterial, beispielsweise Messing oder verzinktem Kupfer, gefertigt und weisen an ihrer der Vorderkante 12 des Solardeckels zugewandten Seite eine Auflauframpe 34 auf, der sich in Richtung auf die Vorderkante 12 eine von der Abdeckung 24 überdeckte Abflachung anschließt. Sie sind über ihre Rückseiten 32 mittels des Einbettungsmaterials 26 adhäsiv an der Deckelplatte 20 angebracht und weisen an ihrer der Auflauframpe 34 abgewandten Seite einen Absatz auf, der als Lötfahne ausgebildet ist und der elektrischen Ankopplung der Zellenverbinder 28 dient. Zwischen der Auflauframpe 34 und der Lötfahne befindet sich ein im wesentlichen parallel zur Deckelplatte 20 verlaufender Kontaktbereich 31.

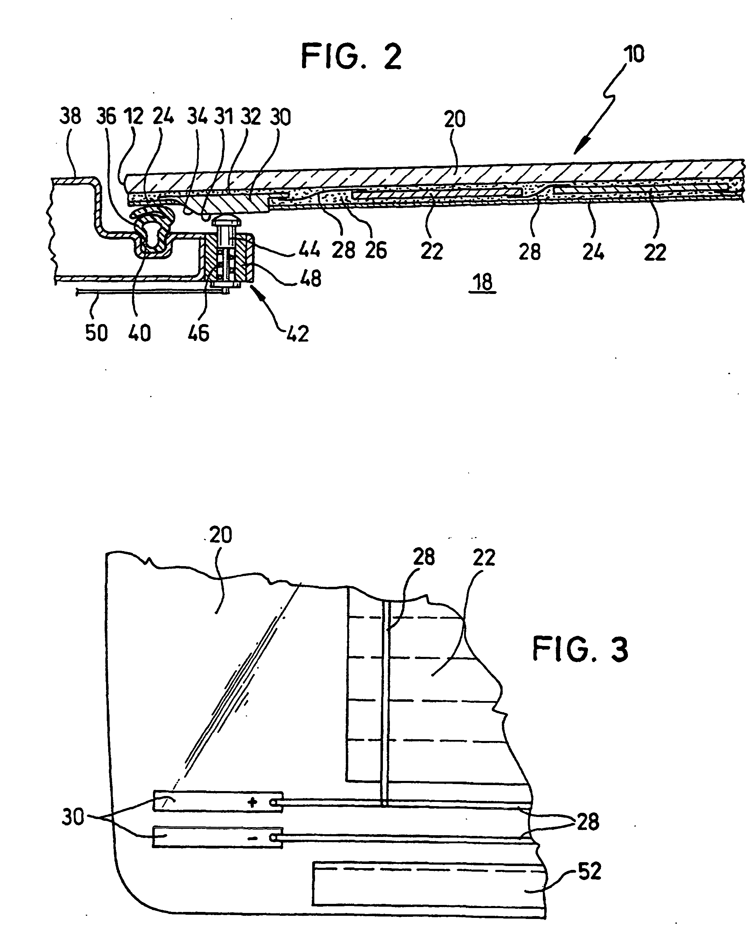

In einem dachseitigen Rahmen 38 ist eine umlaufende Deckelranddichtung 36 in einer Nut 40 vorgesehen. Die beiden dachseitigen Kontakte 42 sind jeweils federnd ausgebildet und werden über einen Einsatzkörper 48 im Rahmen 38 festgehalten. Der elektrische Kontakt zu den beiden deckelseitigen Kontakten 30 wird über jeweils einen Stößel 44 hergestellt, der mit abgerundeten Kontaktflächen versehen und in dem isolierend ausgeführten Einsatzkörper 48 federnd dergestalt aufgenommen ist, daß er bei geschlossenem Solardeckel 10 im wesentlichen senkrecht mit Bezug zum Kontaktbereich 31 des deckelseitigen Kontakts 30 durch eine Feder 46 vorgespannt ist. Auch wenn der Solardeckel 10 in eine Lüfterstellung gebracht wird, indem die Hinterkante 14 des Solardeckels 10 über die feste Dachhaut 16 angehoben wird, wobei seine Vorderkante 12 im wesentlichen in der in Fig. 2 gezeigten Position verbleibt, ist gewährleistet, daß die federnden Stößel 44 eine sichere elektrische Verbindung mit den dachseitigen Kontakten 30 aufrecht erhalten. Ein nicht dargestellter Verbraucher oder Sammler, beispielsweise ein Lüftergebläse oder eine Bordbatterie, ist über Elektrokabel 50 elektrisch mit den dachseitigen Kontakten 42 verbunden.

Beim Öffnen des Solardeckels 10 wird dieser von der in Fig. 2 gezeigten geschlossenen Stellung wie oben geschildert zunächst in eine Lüfterstellung gebracht und dann in Fahrtrichtung, d.h. in Fig. 2 nach rechts, verschoben. Dabei gleiten die Stößel 44 zunächst auf den Kontaktbereichen 31 der deckelseitigen Kontakte 30, folgen dann unter Entspannung der Feder 46 den in Richtung auf die Deckelplatte 20 verlaufenden Auflauframpen 34 und werden schließlich, bevor sie die innenliegende Abdeckung 24 berühren, durch eine nicht dargestellte Rückhaltevorrichtung in ihrer ausgefahrenen Endstellung festgehalten. Die elektrische Verbindung zwischen Verbraucher und Solarzellen ist ab dem hierdurch definierten Öffnungsweg des Solardeckels unterbrochen. Beim Schließen des Solardeckels 10 wird unter Umkehrung des geschilderten Ablaufs der elektrische Kontakt wieder geschlossen, wobei die Auflauframpen 34 der deckelseitigen Kontakte verschleißmindernd mit den abgerundeten Kontaktflächen der Stößel 44 zusammenwirken.

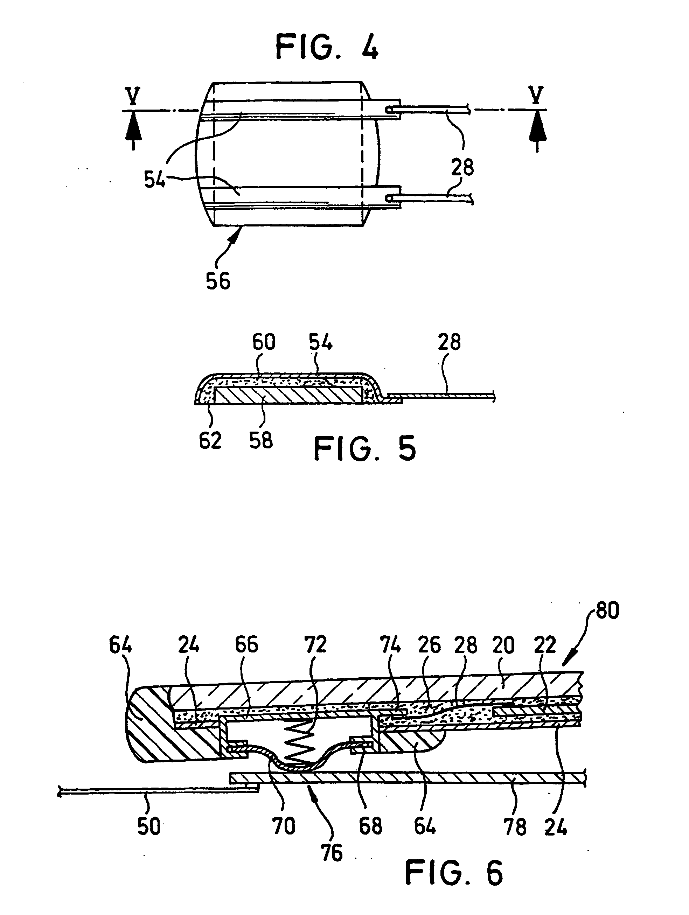

Bei der in Fig. 3 vergrößert dargestellten Draufsicht auf den vorderen Eckbereich des Solardeckels 10 ist, wie auch in den Schnittdarstellungen gemäß den Fign. 2 und 6, zur übersichtlicheren Darstellung eine Lackschicht oder sogenannte Fritte nicht gezeigt, mit der die Innenseite der Deckelplatte 20 in an sich bekannter Weise im wesentlichen im Randbereich sowie im Bereich der Zellenverbinder 28 versehen ist, um die unter der Fritte liegenden Bauteile optisch abzudecken. Ein Deckelinnenblech 52 ist auf beiden Seiten des Solardeckels 10 auf der inneren Abdeckung 24 aufgeklebt und kann zusätzlich mit Schrauben fixiert sein, die die Deckelplatte 20 durchsetzen. Mit dem Deckelinnenblech 52 ist ein nichtveranschaulichter Verstellmechanismus verbunden, der in üblicher Weise ausgelegt ist, um den Solardeckel 10 in seine Lüfterstellung zu bringen und zu verschieben.

Bei der abgewandelten Ausführungsform der deckelseitigen Kontakte gemäß den Fign. 4 und 5 sind zwei Kontaktstreifen 54 zu einer insgesamt mit 56 bezeichneten Kontaktplatte zusammengefaßt und mit einer Stabilisierung 58, beispielsweise einer GFK-Platte, verbunden. Die Fixierung der als Blechstreifen ausgeführten deckelseitigen Kontakte 54 erfolgt mittels eines Einbettungsmaterials 60 in einem Laminierungsprozeß. Die Kontaktstreifen 54 der so vorbereitete Kontaktplatte 56 werden mit den Solarzellen 22 über die Zellenverbindern 28 elektrisch kontaktiert und dann gemeinsam mit den Solarzellen 22 auf die Deckelplatte 20 auflaminiert, wobei die Rückseite 62 der Kontaktplatte 56 adhäsiv über das Einbettungsmaterial 26 mit der Deckelplatte 20 verbunden wird.

Fig. 6 zeigt eine abgewandelte Ausführungsform eines Solardeckels 80, bei der übereinstimmende Bauelemente durch die gleichen Bezugszeichen gekennzeichnet sind wie bei der Ausführungsform gemäß den Fign. 1 bis 3. Der Solardeckel 80 unterscheidet sich im wesentlichen von dem zuvor beschriebenen Solardeckel 10 dadurch, daß die deckelseitigen und dachseitigen Kontakte nicht nur in der vorderen Endstellung des Solardeckels 80 in elektrischem Kontakt stehen, sondern daß sie den elektrischen Kontakt in jeder Stellung des Solardeckels 80, also auch bei geöffnetem oder teilweise geöffnetem Solardeckel 80, aufrecht erhalten. Hierzu sind im Solardeckel 80 in der Nähe seiner Vorderkante zwei deckelseitige Kontakte 76 federnd ausgebildet und dachseitig zwei Stromschienen 78 vorgesehen, die sich über den gesamten Öffnungsweg des Solardeckels 80 erstrecken und über Elektrokabel 50 mit Verbrauchern verbunden sind. Eine solche Ausführungsform mit Stromschienen eignet sich besonders für Spoilerdächer oder Oberfirstschiebedächer, bei denen der Deckel stets in vollem Umfang der Sonne ausgesetzt ist.

Die beiden deckelseitigen Kontakte 76 besitzen jeweils ein etwa U-förmiges Gehäuse 66 mit zwei Aufnahmenuten 68 und einem Ansatz 74, der als Lötfahne zum Anlöten der Zellenverbinder 28 ausgeformt ist. Die Aufnahmenuten 68 dienen der Halterung eines Federkontaktes 70, der seinerseits in seiner Federwirkung von einer Feder 72 verstärkt wird, die vorgespannt in dem Gehäuse 66 zwischen einer Gehäuserückwand und dem Federkontakt 70 eingesetzt ist.

Im Unterschied zum rahmenlosen Solardeckel 10 handelt es sich beim Solardeckel 80 um einen umschäumten Solardeckel mit einem im Randbereich der Deckelplatte 20 angeschäumten Kunststoffrahmen 64, welcher im Bereich der deckelseitigen Kontakte 76 Aussparungen aufweist. Der Solardeckel 80 ist Teil eines an sich bekannten Hebeschiebedaches, so daß er mit seiner Hinterkante über die feste Dachhaut 16 nach oben ausgestellt und nach hinten über die feste Dachhaut 16 geschoben werden kann. Ein an sich ebenfalls bekannter Verstellmechanismus ist mit nicht dargestellten seitlichen Deckelinnenblechen verbunden, die im Unterschied zum rahmenlosen Solardeckel 10 nicht mit der innenliegenden Abdeckung 24 verklebt und bei Bedarf mit der Deckelplatte 20 verschraubt sind, sondern die in üblicher Weise in den Kunststoffrahmen 64 eingeschäumt sind.

### Bezugszeichenliste

- 10: Solardeckel
- 12: Vorderkante
- 14: Hinterkante
- 16: Feste Dachhaut
- 18: Dachöffnung
- 20: Deckelplatte
- 22: Solarzelle
- 24: Abdeckung
- 26: Einbettungsmaterial
- 28: Zellenverbinder
- 31: Kontaktbereich
- 30: Deckelseitiger Kontakt
- 32: Rückseite (von 30)
- 34: Auflauframpe
- 36: Deckelranddichtung
- 38: Rahmen
- 40: Nut
- 42: Dachseitige Kontakt
- 44: Stößel
- 46: Feder
- 48: Einsatzkörper
- 50: Elektrokabel
- 52: Deckelinnenblech
- 54: Kontaktstreifen
- 56: Kontaktplatte
- 58: Stabilisierung
- 60: Einbettungsmaterial
- 62: Rückseite
- 64: Kunststoffrahmen
- 66: Gehäuse
- 68: Aufnahmenut
- 70: Federkontakt
- 72: Feder
- 74: Ansatz
- 76: Deckelseitiger Kontakt
- 78: Stromschiene
- 80: Solardeckel

## Patentansprüche

1. Anordnung
- mit einem Fahrzeugdach,
- mit einem Solardeckel (10, 80) zum wahlweisen Verschließen oder teilweisen Freilegen einer im Fahrzeugdach vorgesehenen Dachöffnung (18), der zwischen einer außenliegenden Deckelplatte (20) und einer innenliegenden Abdeckung (24) angeordnete Solarzellen (22) aufweist,
- mit mindestens einem aus den Solarzellen gespeisten Verbraucher oder Sammler, der von dem Solardeckel (10, 80) getrennt ist, und
- mit einer Kontakteinrichtung zum Herstellen einer elektrischen Verbindung zwischen den Solarzellen (22) und dem Verbraucher, wobei die Kontakteinrichtung deckelseitige sowie dachseitige Kontakte (30, 56, 76; 42, 78) aufweist, die zumindest in einer Solardeckelstellung die elektrische Verbindung schließen, auch wenn eine Kante (14) des Solardeckels (10, 80) über oder unter eine feste Dachhaut (16) des Fahrzeugdachs verschwenkt ist, und wobei die deckelseitigen oder die dachseitigen Kontakte (30, 56, 76; 42, 78) mit Bezug zu ihren jeweiligen Gegenkontakten in Richtung auf diese federnd ausgebildet sind
**dadurch gekennzeichnet, daß**
- die deckelseitigen Kontakte (30, 56, 76) als in den Solardeckel (10, 80) integrierte Kontakte ausgeführt sind und
- die deckelseitigen Kontakte (30, 56, 76) mittels eines zwischen der außenliegenden Deckelplatte (20) und einer innenliegenden Abdeckung (24) angeordneten Einbettungsmaterials (26, 60) adhäsiv mit der Deckelplatte (20) verbunden sind.

2. Anordnung nach Anspruch 1, **dadurch gekennzeichnet, daß** die federnd ausgebildeten Kontakte einen federnd vorgespannten Stößel (44) oder Federkontakt (70) und die Gegenkontakte einen unnachgiebigen Kontaktbereich (31) aufweisen.

3. Anordnung nach Anspruch 2, **dadurch gekennzeichnet, daß** die unnachgiebigen Kontaktbereiche Stromschienen (78) bilden, die mit den federnd vorgespannten Stößeln (44) oder Federkontakten (70) der federnd ausgebildeten Kontakte während des gesamten Öffnungsweges des Solardeckels (10, 80) in elektrischem Kontakt bleiben.

4. Anordnung nach Anspruch 1 oder 2, **dadurch gekennzeichnet, daß** bei geöffnetem oder teilweise geöffnetem Solardeckel (10, 80) die deckelseitigen und die dachseitigen Kontakte (30, 56; 42) die elektrische Verbindung zwischen Verbraucher und Solarzellen öffnen.

5. Anordnung nach Anspruch 4, **dadurch gekennzeichnet, daß** die deckelseitigen Kontakte (30, 56) in der Nähe der Vorderkante der Deckelplatte angeordnet sind und einen unnachgiebigen Kontaktbereich (31) aufweisen, der im wesentlichen nur in der vorderen Solardeckelendstellung mit den federnd ausgebildeten dachseitigen Kontakten in Kontakt (42) steht.

6. Anordnung nach Anspruch 5, **dadurch gekennzeichnet, daß** die deckelseitigen Kontakte (54) in einer gemeinsamen Kontaktplatte (56) zusammengefaßt sind.

7. Anordnung nach Anspruch 6, **dadurch gekennzeichnet, daß** die Kontaktplatte (56) eine Stabilisierung (58) umfaßt, auf der die deckelseitigen Kontakte aufgebracht (54) sind.

8. Anordnung nach einem der vorhergehenden Ansprüche, **dadurch gekennzeichnet, daß** wenigstens einer der Kontakte (30, 56 76; 42) in einer Verschieberichtung des Solardeckels (10, 80) wirksame Auflauframpen (34) aufweist.

9. Anordnung nach einem der vorhergehenden Ansprüche, **gekennzeichnet durch** einen angeschäumten oder angespritzten Kunststoffrahmen (64) im Randbereich der Deckelplatte (20), der im Bereich der deckelseitigen Kontakte (76) Aussparungen aufweist.

10. Anordnung nach einem der vorhergehenden Ansprüche, **dadurch gekennzeichnet, daß** für die innenliegende Abdeckung (24) eine Kunststoffolie verwendet wird, die im Bereich der deckelseitigen Kontakte (30, 56, 76) Aussparungen aufweist.

## Claims

1. Arrangement
- having a vehicle roof,
- having a solar panel (10, 80) for the optional closure or partial opening of a roof opening (18) provided in the vehicle roof, which has solar cells (22) arranged between an outer cover plate (20) and an inner cover (24),
- having at least one load or collector which is fed from the solar cells and which is separate from the solar panel (10, 80), and
- having a contact-making device for producing an electrical connection between the solar cells (22) and the load, the contact-making device having contacts (30, 56, 76; 42, 78) on the panel and on the roof which, at least in a solar panel position, make the electrical connection, even if an edge (14) of the solar panel (10, 80) is pivoted above or below a fixed roof skin (16) of the vehicle roof, and the contacts (30, 56, 76; 42, 78) on the panel or on the roof being designed to be sprung in relation to their respective mating contacts, in the direction of the latter,
**characterized in that**
- the contacts (30, 56, 76) on the panel are designed as contacts integrated into the solar panel (10, 80) and
- the contacts (30, 56, 76) on the panel are connected adhesively to the cover plate (20) by means of an embedding material (26, 60) arranged between the outer cover plate (20) and an inner cover (24).

2. Arrangement according to Claim 1, **characterized in that** the sprung contacts have a sprung prestressed plunger (44) or spring contact (70), and the mating contacts have an unyielding contact region (31).

3. Arrangement according to Claim 2, **characterized in that** the unyielding contact regions form bus bars (78), which remain in electrical contact with the sprung prestressed plungers (44) or spring contacts (70) of the sprung contacts during the entire opening travel of the solar panel (10, 80).

4. Arrangement according to Claim 1 or 2, **characterized in that**, when the solar panel (10, 80) is opened or partly opened, the contacts (30, 56; 42) on the panel and the roof break the electrical connection between load and solar cells.

5. Arrangement according to Claim 4, **characterized in that** the contacts (30, 56) on the panel are arranged in the vicinity of the front edge of the cover plate and have an unyielding contact region (31), which is in contact (42) with the sprung contacts on the roof substantially only in the front solar panel end position.

6. Arrangement according to Claim 5, **characterized in that** the contacts (54) on the panel are brought together in a common contact plate (56).

7. Arrangement according to Claim 6, **characterized in that** the contact plate (56) comprises a stabilising means (58), to which the contacts on the panel are fitted (54).

8. Arrangement according to one of the preceding claims, **characterized in that** at least one of the contacts (30, 56, 76; 42) has run-on ramps (34) which are effective in a displacement direction of the solar panel (10, 80).

9. Arrangement according to one of the preceding claims, **characterized by** a foamed-on or injection-moulded plastic frame (64) in the edge region of the cover plate (20), which has cutouts in the region of the contacts (76) on the panel.

10. Arrangement according to one of the preceding claims, **characterized in that** a plastic film which has cutouts in the region of the contacts (30, 56, 76) on the panel is used for the inner cover (24).

## Revendications

1. Dispositif
- avec un toit de véhicule,
- avec un couvercle solaire (10, 80) pour au choix fermer ou dégager partiellement une ouverture de toit (18) prévue dans le toit de véhicule, lequel couvercle solaire présente des cellules solaires (22) disposées entre une plaque couvercle extérieure (20) et une couverture ou un revêtement intérieur (24),
- avec au moins un consommateur ou accumulateur alimenté par les cellules solaires, lequel est séparé du couvercle solaire (10, 80), et
- avec un dispositif de contact pour établir une liaison électrique entre les cellules solaires (22) et le consommateur, le dispositif de contact présentant des contacts côté couvercle ainsi que côté toit (30, 56, 76 ; 42, 78) qui ferment la liaison électrique au moins dans une position du couvercle solaire, même quand un bord (14) du couvercle solaire (10, 80) est incliné au-dessus ou au-dessous d'une paroi de toit fixe (16) du toit de véhicule, et les contacts côté couvercle ou côté toit (30, 56, 76 ; 42, 78) étant conçus par rapport à leurs contacts opposés respectifs de manière à faire ressort en direction de ceux-ci,
**caractérisé par le fait que**
- les contacts côté couvercle (30, 56, 76) sont réalisés sous la forme de contacts intégrés dans le couvercle solaire (10, 80) et
- les contacts côté couvercle (30, 56, 76) sont reliés à la plaque couvercle (20) de manière adhésive au moyen d'un matériau d'enrobement (26, 60) disposé entre la plaque couvercle extérieure (20) et la couverture ou le revêtement intérieur (24).

2. Dispositif selon la revendication 1, **caractérisé par le fait que** les contacts conçus pour faire ressort présentent un poussoir précontraint par ressort (44) ou un contact à ressort (70) et les contacts opposés une zone de contact non flexible (31).

3. Dispositif selon la revendication 2, **caractérisé par le fait que** les zones de contact non flexibles forment des rails conducteurs (78) qui restent en contact électrique avec les poussoirs précontraints par ressort (44) ou les contacts à ressort (70) des contacts conçus pour faire ressort pendant toute la course d'ouverture du couvercle solaire (10, 80).

4. Dispositif selon la revendication 1 ou 2, **caractérisé par le fait que** les contacts côté couvercle et les contacts côté toit (30, 56 ; 42) ouvrent la liaison électrique entre le consommateur et les cellules solaires lorsque le couvercle solaire (10, 80) est ouvert ou partiellement ouvert.

5. Dispositif selon la revendication 4, **caractérisé par le fait que** les contacts côté couvercle (30, 56) sont disposés à proximité du bord avant de la plaque couvercle et présentent une zone de contact non flexible (31) qui est essentiellement en contact (42) avec les contacts côté toit conçus pour faire ressort seulement dans la position finale avant du couvercle solaire.

6. Dispositif selon la revendication 5, **caractérisé par le fait que** les contacts côté couvercle (54) sont regroupés sur une plaque de contact commune (56).

7. Dispositif selon la revendication 6, **caractérisé par le fait que** la plaque de contact (56) comprend un corps stabilisateur (58) sur lequel les contacts côté couvercle (54) sont appliqués.

8. Dispositif selon l'une des revendications précédentes, **caractérisé par le fait qu'**au moins un des contacts (30, 56, 76 ; 42) présente des rampes d'accostage actives dans un sens de déplacement du couvercle solaire (10, 80).

9. Dispositif selon l'une des revendications précédentes, **caractérisé par** un cadre en matière plastique (64) rapporté par moussage ou moulage par injection sur les bords de la plaque couvercle (20), lequel présente des évidements au niveau des contacts côté couvercle (76).

10. Dispositif selon l'une des revendications précédentes, **caractérisé par le fait que** l'on utilise pour la couverture ou le revêtement intérieur (24) une feuille de plastique qui présente des évidements au niveau des contacts côté couvercle (30, 56, 76).
